(19) Europäisches Patentamt
European Patent Office
Office européen des brevets

(11) EP 1 895 565 A1

(12) EUROPEAN PATENT APPLICATION

(43) Date of publication:
05.03.2008 Bulletin 2008/10

(51) Int Cl.:
$H01J\ 37/32^{(2006.01)}$

(21) Application number: 07115466.0

(22) Date of filing: 31.08.2007

(84) Designated Contracting States:
AT BE BG CH CY CZ DE DK EE ES FI FR GB GR
HU IE IS IT LI LT LU LV MC MT NL PL PT RO SE
SI SK TR
Designated Extension States:
AL BA HR MK YU

(30) Priority: 01.09.2006 JP 2006237805

(71) Applicant: Canon Kabushiki Kaisha
Ohta-Ku,
Tokyo 146-8501 (JP)

(72) Inventors:
• Suzuki, Nobumasa
Ohta-ku Tokyo (JP)
• Kitagawa, Hideo
Ohta-ku Tokyo (JP)

(74) Representative: Sharp, Alan Cooper
Canon Europe Ltd.
European Patent Department
6 Roundwood Avenue
Stockley Park
Middlesex, Uxbridge UB11 1JA (GB)

(54) **Plasma processing apparatus and method**

(57) A plasma processing apparatus comprises a plasma processing chamber (101) and a source of microwaves. The microwaves are introduced to the processing chamber by a slotted annular waveguide (108) having inner (114a) and outer (114b) arc-shaped slots. The distance (Ls) between the centerline of the inner and outer arc-shaped slots is set to be an even multiple of a half wavelength of a microwave surface wave (115) propagating along a surface of a dielectric window (107) of the chamber. A distance (Le) between the centerline of the outer arc-shaped slot and an outer periphery of the dielectric window is set to be an odd multiple of the half wavelength of the microwave surface wave.

## FIG. 1B

$$Ls = n\lambda s$$
$$Le = (2m+1)\lambda s / 2$$
$$Lc = l\lambda s / 4$$
$$(n, m, l: INTEGER)$$

**Description**

BACKGROUND OF THE INVENTION

Field of the Invention

The present invention relates to a plasma processing apparatus and method which generate plasma by using microwave excitation. More particularly, the present invention relates to a plasma processing apparatus and method which can generate a plasma with higher uniformity in the vicinity of a substrate.

Description of the Related Art

Recently, plasma processing techniques have become more important to meet demands for reduction of temperatures in various electronic device manufacturing processes.

In particular, plasmas having a high density of $1e12$ $cm^{-3}$ or more and low electron temperature of 1 eV or below can be obtained with microwave plasma using, as an excitation source, microwaves (that is, an electromagnetic wave having a higher frequency than a radio wave).

Because plasmas using microwaves as the excitation source can realize fast processing with low damage and high quality, further development of microwave plasmas is expected in the future.

A plasma processing apparatus using a microwave plasma is known in processes for chemical vapor deposition (CVD), etching, ashing, nitriding/oxidization, cleaning, and so on.

In microwave plasma processing apparatus, electrons can be accelerated by an electric field having a high frequency and gas molecules can be efficiently excited, ionized and decomposed.

Because gas excitation efficiency, ionization efficiency, and decomposition efficiency of a microwave plasma are all high, a high-density plasma can be relatively easily produced with microwave excitation. Thus, a microwave plasma can realize processing at higher rates and lower temperatures.

Another advantage of a microwave plasma is that because above a threshold density, the bulk plasma itself acts to attenuate the microwave electric field and to relax the electron temperature, the processing can be performed with less damage to the substrate and higher quality.

Further, because microwaves have the property of passing through a dielectric, the plasma processing apparatus can be of the electrodeless discharge type. Accordingly, clean plasma processing with less metal contamination can be realized.

Japanese Patent Laid-Open No. 2000-138171 proposes a microwave plasma processing apparatus using, as a device for uniformly and efficiently introducing a microwave, an endless annular waveguide in which a plurality of arc-shaped slots are formed in the H plane.

Fig. 5A is a schematic view for explaining the construction of the known microwave plasma processing apparatus. Fig. 5B is a partial view for explaining the arrangement of strong-interference dual arc-shaped slots in the known microwave plasma processing apparatus.

Figs. 6A and 6B are schematic views for explaining the construction of a plasma generation mechanism in the known microwave plasma processing apparatus.

A plasma processing chamber 501 is surrounded by walls and an inner space of the plasma processing chamber 501 can be evacuated to a vacuum state by an evacuation unit 506 (described later).

A target substrate 502 to be processed is held on a support 503 installed within the plasma processing chamber 501, and it is one of various kinds of substrates (base plates) such as semiconductor substrates.

A substrate temperature adjustment unit 504 is, for example a heater installed under the support 503 near the target substrate 502. Temperature of the target substrate 502 is adjusted with heat applied from the heater.

A gas introduction unit 505 is disposed around the plasma processing chamber 501 and introduces processing gas to the plasma processing chamber 501 at a predetermined flow rate.

The evacuation unit 506 evacuates air in the plasma processing chamber 501 and maintains the interior of the plasma processing chamber 501 at a predetermined pressure.

A dielectric window 507 is made of a dielectric in the form of a flat plate and serves to separate the interior of the plasma processing chamber 501 from the atmosphere side.

A slotted endless annular waveguide (strong-interference dual arc-shaped slots) 508 has inner arc-shaped slots 514a and outer arc-shaped slots 514b.

The slotted endless annular waveguide 508 introduces microwaves to the plasma processing chamber 501 through the dielectric window 507 from the inner arc-shaped slots 514a and the outer arc-shaped slots 514b.

An inlet E branch 511 introduces the microwave to the slotted endless annular waveguide 508 through an annular waveguide passage 512.

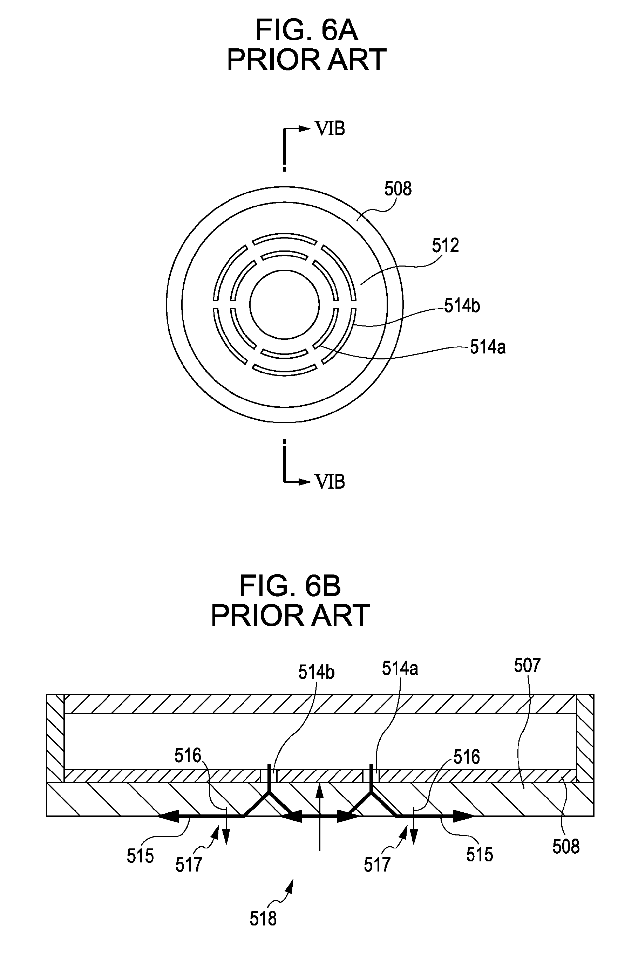

As shown in Fig. 6B, the inner arc-shaped slots 514a and the outer arc-shaped slots 514b of the slotted endless annular waveguide 508 generate surface waves 515 propagating along the surface of the dielectric window 507.

Also, as shown in Fig. 6B, a surface standing wave 516 is generated by interference between the surface waves 515 from the slots 514a and 514b adjacent to each other.

The surface standing wave 516 generates primary plasma 517, and diffusion of the primary plasma 517 generates a plasma bulk 518.

Assume now that the interval from the center of the waveguide 508 to the centerline of each inner arc-shaped slot 514a is Lc and the interval between the centerlines of the inner and outer arc-shaped slots 514a, 514b is Ls. Further, the interval between the centerline of each outer arc-shaped slot 514b and the outer periphery of the waveguide 508 (i.e., the outer periphery of the dielectric window 507) is assumed to be Le.

The interval Ls between the centerlines of the inner and outer arc-shaped slots 514a, 514b is expressed by Eq. 1 given below;

$$\mathrm{Ls} \; = \; (2\mathrm{n} \; + \; 1)\lambda\mathrm{s}/2 \qquad\qquad …\mathrm{Eq.} \; 1$$

where n is an integer and $\lambda$s is the wavelength of the surface wave 515.

Plasma processing is performed as follows. The interior of the plasma processing chamber 501 is evacuated to a vacuum state through an evacuation system (including, e.g., the evacuation unit 506).

Then, the processing gas is introduced to the plasma processing chamber 501 at a predetermined flow rate through the gas introduction unit 505 disposed around the plasma processing chamber 501.

Then, a conductance valve (not shown) disposed in the evacuation system (not shown) is adjusted to hold the interior of the plasma processing chamber 501 at a predetermined pressure.

Then, desired electric power is supplied from a microwave power supply (not shown) to the plasma processing chamber 501 through the slotted endless annular waveguide 508.

At that time, the microwave introduced to the slotted endless annular waveguide 508 is distributed to the right and the left by the inlet E branch 511 in an inlet portion. The distributed microwaves interfere with each other in the annular waveguide passage 512 to generate an "antinode" of an intra-waveguide standing wave every 1/2 of the wavelength of the microwave in the annular waveguide passage 512.

Plasma is generated in the plasma processing chamber 501 through the arc-shaped slots 514a and 514b located at positions away from the antinode of the standing wave where a current flowing along an inner wall surface of the waveguide is intensified.

In other words, plasma is generated by the microwaves introduced to the plasma processing chamber 501 through the arc-shaped slots 514a and 514b of the slotted endless annular waveguide 508 after passing through the dielectric window 507.

When the electron density of the plasma exceeds a cutoff density ($7.5 \times 10^{10}$ cm$^{-3}$ in the case of the microwave having a frequency of 2.45 GHz), the microwave having entered an interface between the dielectric window 507 and the plasma cannot propagate into the plasma.

As a result, the microwave having entered the interface between the dielectric window 507 and the plasma propagates as a surface wave 515 along the surface of the dielectric window 507.

More exactly speaking, when the electron density of the plasma exceeds a surface-wave mode generation threshold density ($3.4 \times 10^{11}$ cm$^{-3}$ when using a quartz window), the microwave propagates as a surface wave 515 along the surface of the dielectric window 507.

Further, the surface waves 515 introduced through the adjacent arc-shaped slots 514a and 514b interfere with each other to generate a surface standing wave 516 that has an antinode every 1/2 of the wavelength of the surface wave 515.

The primary plasma 517 having ultra-high density and high electron temperature is generated in the vicinity of the dielectric window 507 by the surface standing wave 516 localized near the surface of the dielectric window 507.

The primary plasma 517 diffuses toward the target substrate 502 and is relaxed so as to generate the plasma bulk 518 having high density and low electron temperature near the target substrate 502.

The processing gas is excited by the generated high-density plasma and interacts with the surface of the target substrate 502 placed on the support 503.

By using the microwave plasma processing apparatus thus constructed, a plasma having high density and low electron temperature is generated in a large-diameter space having a diameter of about 300 mm at microwave power of 1 kW or more with uniformity of about $\pm$ 5%.

In other words, a high-density and low-electron-temperature plasma having electron density of $10^{11}$ cm$^{-3}$ or more, electron temperature of 1.5 eV or below, and plasma potential of 7 V or below is generated in a large-diameter space having a diameter of about 300 mm with uniformity of about ± 5%.

Therefore, the processing gas can be supplied in a sufficiently activated state to the target substrate 502. Further, since surface damage of the target substrate 502 due to incident ion bombardment is also reduced, uniform and fast processing can be performed with high quality even at low temperatures.

In trying to obtain the high-density and low-electron-temperature plasma with high uniformity of ± 2% or less by using the above-described microwave plasma processing apparatus, however, the surfaces waves 515 propagate in directions perpendicular to the slots, i.e., in the radial direction along the surface of the dielectric window 507.

Thus, because the surface waves 515 propagate in the radial direction along the surface of the dielectric window 507, there is a possibility that the surfaces waves 515 strongly interfere with each other in regions between the inner and outer arc-shaped slots 514a, 514b, while a plasma processing rate becomes insufficient in other regions, i.e., in an outer peripheral portion and a central portion.

SUMMARY OF THE INVENTION

The present invention provides a plasma processing apparatus and method which can realize higher uniformity of electric field strength of a surface wave by intensifying electric field strength of the surface wave in an outer peripheral portion and a central portion to adjust the distribution of the electric field strength in the radial direction.

The present invention in its first aspect provides a plasma processing apparatus as specified in claims 1 to 6.

The present invention in its second aspect provides a plasma processing method as specified in claim 7.

According to the plasma processing apparatus of the present invention, the electric field strength of a surface wave in an outer peripheral portion and a central portion of the waveguide is intensified to optimize the distribution of the electric field strength in the radial direction. As a result, higher uniformity can be realized in the distribution of the electron density near the target substrate to be processed, and stable plasma processing can be realized with higher accuracy and/or uniformity.

Further features of the present invention will become apparent from the following description of exemplary embodiments with reference to the attached drawings.

BRIEF DESCRIPTION OF THE DRAWINGS

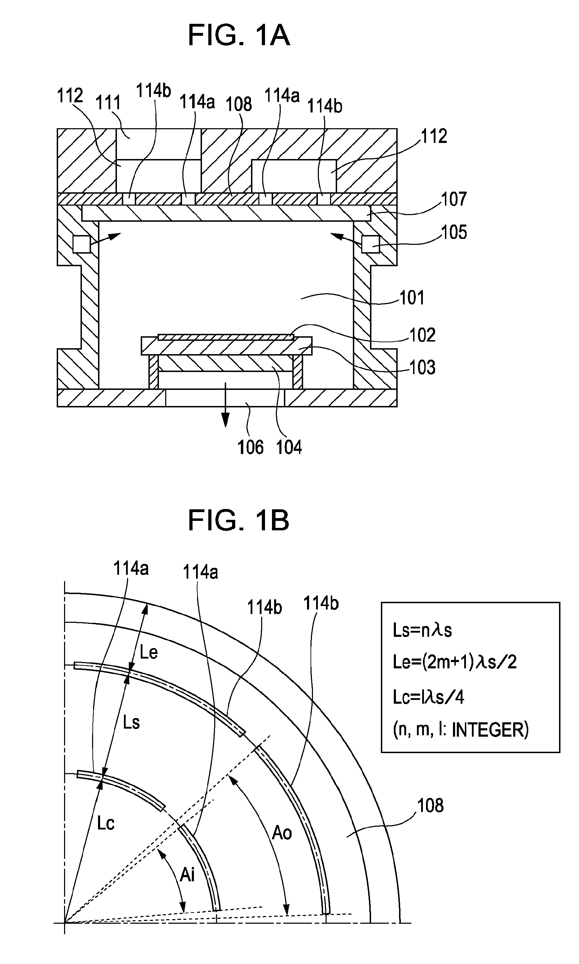

Fig. 1A is a schematic view of the construction of a microwave plasma processing apparatus according to a first embodiment of the present invention.

Fig. 1B is a partial view of the arrangement of weak-interference dual arc-shaped slots in the microwave plasma processing apparatus according to the first embodiment of the present invention.

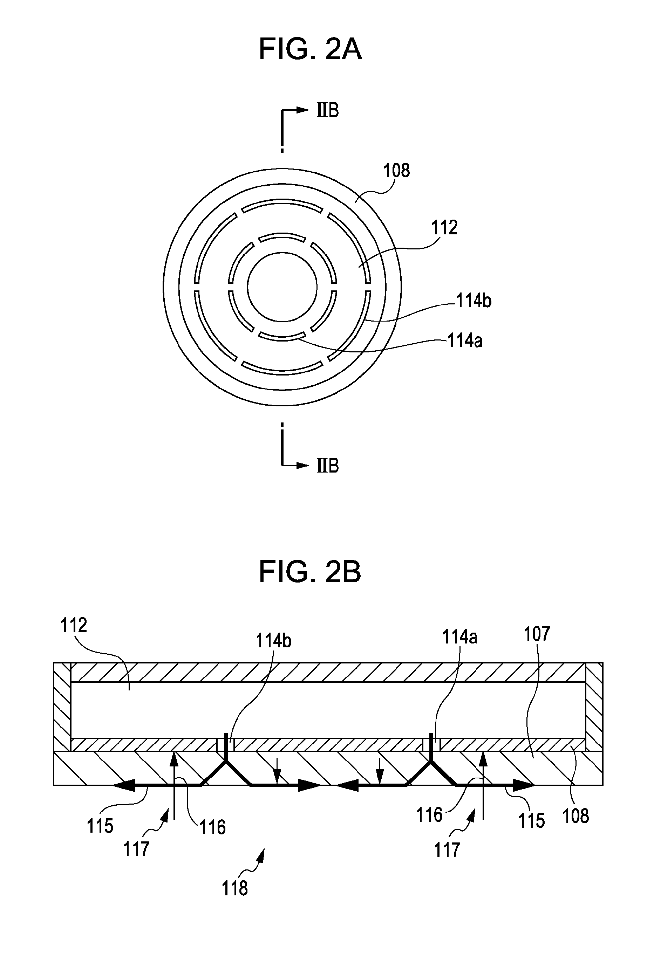

Fig. 2A is a schematic view of the construction of a plasma generation mechanism in the microwave plasma processing apparatus according to the first embodiment of the present invention.

Fig. 2B is a sectional view taken along a line IIB-IIB in Fig. 2A.

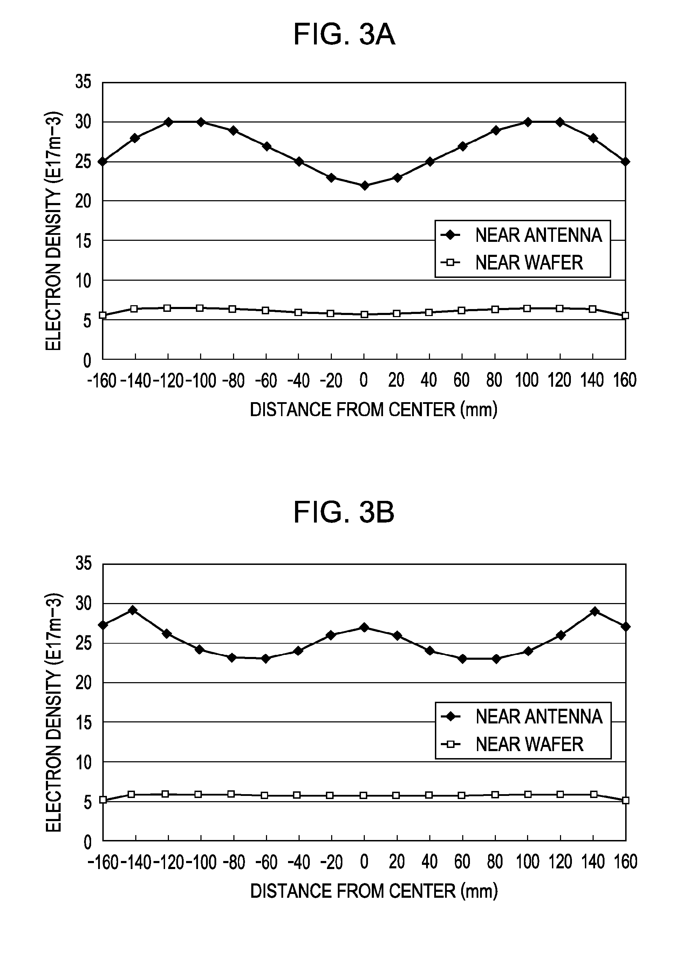

Fig. 3A is a graph showing the distribution of electron density near a slot antenna and near a target substrate to be processed when the known strong-interference dual arc-shaped slots (i.e., the known slotted endless annular waveguide) are employed.

Fig. 3B is a graph showing the distribution of electron density near a slot antenna and near a target substrate to be processed when the weak-interference dual arc-shaped slots (i.e., a slotted endless annular waveguide) according to the first embodiment of the present invention are employed.

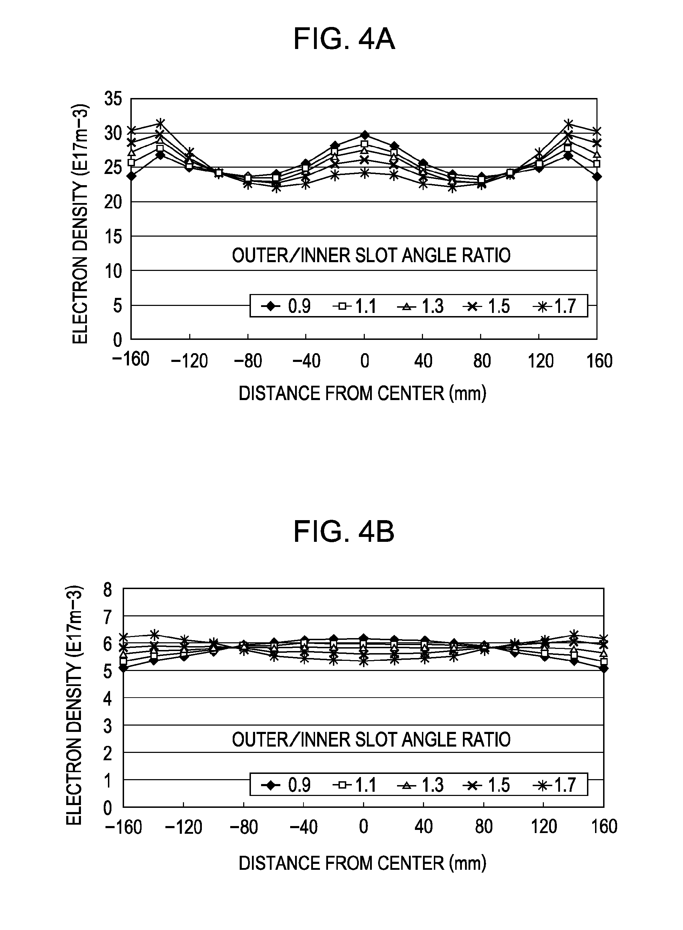

Fig. 4A is a graph showing a distribution of electron density (electric field strength of a surface wave) near the slotted endless annular waveguide in the first embodiment of the present invention with respect to an angle ratio of an aperture angle Ao of an outer arc-shaped slot to an aperture angle Ai of an inner arc-shaped slot.

Fig. 4B is a graph showing a distribution of electron density near the target substrate in the first embodiment of the present invention with respect to the angle ratio of the aperture angle Ao of the outer arc-shaped slot to the aperture angle Ai of the inner arc-shaped slot.

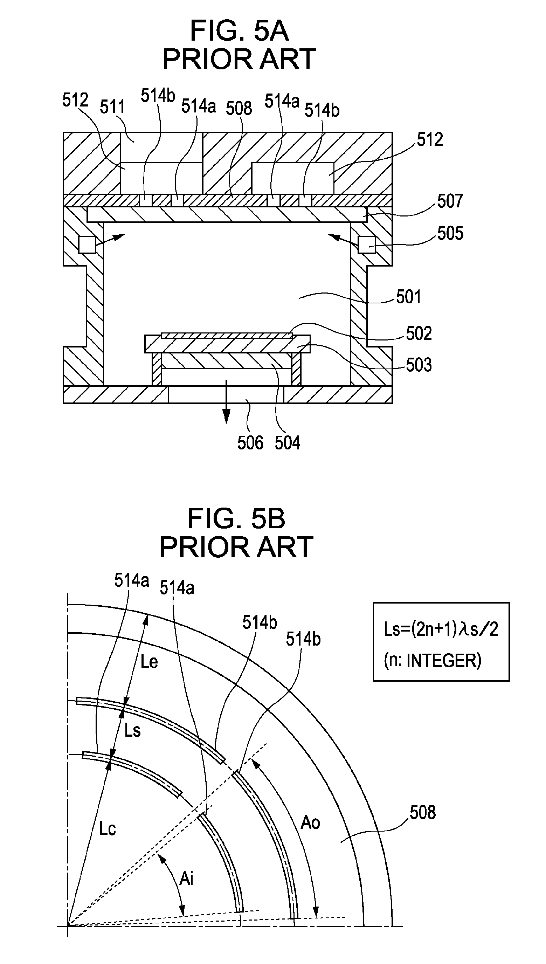

Fig. 5A is a schematic view of the construction of a known microwave plasma processing apparatus.

Fig. 5B is a partial view of the arrangement of the strong-interference dual arc-shaped slots in the known microwave plasma processing apparatus.

Fig. 6A is a schematic view of the construction of a plasma generation mechanism in the known microwave plasma processing apparatus, and Fig. 6B is a sectional view taken along a line VIB-VIB in Fig. 6A.

DESCRIPTION OF THE EMBODIMENTS

The present invention will be described in connection with embodiments by referring to the drawings.

First Embodiment

A first embodiment of the present invention will now be described.

A plasma processing chamber 101 is surrounded by walls and an inner space of the plasma processing chamber 101 can be evacuated to a vacuum state by an evacuation unit 106 (described later).

A target substrate 102 to be processed is held on a support (substrate support unit) 103 installed within the plasma processing chamber 101, and it is one of various kinds of substrates (base plates) such as semiconductor substrates.

A substrate temperature adjustment unit 104 is, for example a heater installed under the support 103 near the target substrate 102. Temperature of the target substrate 102 is adjusted with heat applied from the heater. In the following description, the substrate temperature adjustment unit 104 is referred to as the heater 104. As an alternative or in addition the substrate temperature adjustment unit may comprise or include a cooling means.

A gas introduction unit 105 is disposed in a part of the circumference of the plasma processing chamber 101 and introduces processing gas to the plasma processing chamber 101 at a predetermined flow rate in use.

The evacuation unit 106 evacuates air in the plasma processing chamber 101 and maintains the interior of the plasma processing chamber 101 at a predetermined pressure when processing gas is introduced to the chamber.

A dielectric window 107 is made of a dielectric in the form of a flat plate and serves to separate the interior of the plasma processing chamber 101 from the outside atmosphere side (i.e., the side including a plasma generation mechanism).

A slotted endless annular waveguide (plasma generation mechanism) 108 has inner arc-shaped slots 114a and outer arc-shaped slots 114b which have different diameters and are arranged on two concentric circles. The slotted endless annular waveguide 108 introduces a microwave to the plasma processing chamber 101 through the dielectric window 107.

An inlet E branch 111 introduces the microwaves to the slotted endless annular waveguide 108 through an annular waveguide passage 112.

As shown in Fig. 2B, the inner arc-shaped slots 114a and the outer arc-shaped slots 114b of the slotted endless annular waveguide 108 generate microwave surface waves 115 propagating along the surface of the dielectric window 107.

Also, as shown in Fig. 2B, a surface standing wave 116 is generated by interference between the microwave surface waves 115 from the inner arc-shaped slot (slot antenna) 114a and the outer arc-shaped slot (slot antenna) 114b adjacent to each other.

The surface standing wave 116 generates primary plasma 117, and diffusion of the primary plasma 117 generates a plasma bulk 118.

A microwave generation unit comprises, for example, a magnetron and a slot antenna (both not shown). Microwave introduction units, such as an isolator, an impedance matching device, and the inlet E branch 111, are disposed in a microwave waveguide path from the microwave generation unit to the slotted endless annular waveguide 108.

Assume now that the interval (distance) from the center of the slotted endless annular waveguide 108 to the centerline of each inner arc-shaped slot 114a is Lc and the interval (distance) between the centerlines of the inner and outer arc-shaped slots 114a, 114b is Ls.

Further, the interval (distance) between the centerline of each outer arc-shaped slot 114b and the outer periphery of the waveguide 108 (i.e., the outer periphery of the dielectric window 107) is assumed to be Le. An aperture angle of the inner arc-shaped slot 114a is assumed to be Ai, and an aperture angle of the outer arc-shaped slot 114b is assumed to be Ao.

In the first embodiment, as features of the present invention, the interval Lc, the interval Ls, the interval Le, the aperture angle Ai, and the aperture angle Ao satisfy the following relationships.

First, the interval Ls between the centerline of the inner arc-shaped slot 114a and the centerline of the outer arc-shaped slot 114b is an even multiple of a half wavelength of the microwave surface wave 115 propagating along the surface of the dielectric window 107.

Secondly, the interval Le between the centerline of the outer arc-shaped slot 114b and the outer periphery of the dielectric window 107 is an odd multiple of the half wavelength of the microwave surface wave 115.

Thirdly, the interval between the centerlines of the inner arc-shaped slots 114a, which are positioned symmetrically about an axis, is an integer multiple of the half wavelength of the microwave surface wave 115.

Fourthly, the aperture angle Ao of the outer arc-shaped slot 114b is in the range of 1.1 to 1.5 times the aperture angle Ai of the inner arc-shaped slot 114a.

Fifthly, in the first embodiment of the present invention, the distance between the dielectric window 107 and the support 103 is set to be in the range of, e.g., 30 mm to 120 mm.

Further, the interval Ls between the centerline of the inner arc-shaped slot 114a and the centerline of the outer arc-shaped slot 114b is adjusted, for example, to be relatively increased so that the electron density of the plasma is reduced.

In both the region inside the centerline of the inner arc-shaped slot 114a and the region outside the centerline of the outer arc-shaped slot 114b, the interval of each region is adjusted, for example, to be relatively reduced so that the electron density of the plasma is increased in both regions.

Moreover, the inner and outer arc-shaped slots 114a, 114b are formed at intervals of an equal angle in number corresponding to a ratio of the circumferential length of the annular waveguide passage 112 to the half wavelength of the microwave therein so as to sandwich the positions of antinodes of the standing wave within the annular waveguide passage 112.

Herein, the interval (distance) Ls has a relationship expressed by Eq. 2 given below, the interval (distance) Le has a relationship expressed by Eq. 3 given below, and the interval (distance) Lc has a relationship expressed by Eq. 4 given below;

$$\mathrm{Ls} \; = \; \mathrm{n}\lambda\mathrm{s} \qquad\qquad\qquad\qquad \text{...Eq. 2}$$

$$\mathrm{Le} \; = \; (2\mathrm{m} \; + \; 1)\lambda\mathrm{s}/2 \qquad\qquad \text{...Eq. 3}$$

$$\mathrm{Lc} \; = \; \mathrm{k}\lambda\mathrm{s}/4 \qquad\qquad\qquad\quad \text{...Eq. 4}$$

In Eqs. 2 to 4, n, m and k are each an integer and $\lambda$s is the wavelength of the surface wave 115.

The wavelength $\lambda$s of the surface wave 115 is obtained from Eq. 5 given below;

$$\lambda\mathrm{s} \; = \; \lambda_0\varepsilon_w^{-1/2}\{1 \; - \; (\varepsilon_0\mathrm{m}_e\omega^2/\mathrm{e}^2\mathrm{n}_e)^{1/2}\} \qquad\qquad \text{...Eq. 5}$$

where $\lambda_0$ is the wavelength of the microwave in free space, $\varepsilon_w$ is the specific permittivity of the dielectric window 107, $\varepsilon_0$ is the permittivity of the vacuum, $m_e$ is the electron mass, $\omega$ is the angular frequency of the microwave, e is the elementary electric charge, and $n_e$ is the electron density.

Plasma processing using the plasma processing apparatus is performed as follows. The interior of the plasma processing chamber 101 is first evacuated through an evacuation system (not shown).

Then, the processing gas is introduced to the plasma processing chamber 101 at a predetermined flow rate through the gas introduction unit 105 disposed around the plasma processing chamber 101.

Then, a conductance valve (for example a butterfly valve (not shown)) disposed in the evacuation system is adjusted to hold the interior of the plasma processing chamber 101 at a predetermined pressure.

Then, desired electric power is supplied from a microwave power supply (not shown) to the plasma processing chamber 101 through the inner arc-shaped slots 114a and the outer arc-shaped slots 114b of the slotted endless annular waveguide 108.

At that time, the microwave introduced to the slotted endless annular waveguide 108 is distributed to the right and the left by the inlet E branch 111 and propagates at an intra-waveguide wavelength longer than that in free space.

The distributed microwaves interfere with each other to generate a surface standing wave 116 that has an "antinode" every 1/2 of the intra-waveguide wavelength.

As a result, the microwaves are introduced, after passing through the dielectric window 107, to the plasma processing chamber 101 through the inner arc-shaped slots 114a and the outer arc-shaped slots 114b which are arranged in a crossing relation to a surface current.

Initial high-density plasma is generated near the inner arc-shaped slots 114a and the outer arc-shaped slots 114b by the microwaves introduced to the plasma processing chamber 101.

When the electron density of the initial high-density plasma exceeds a cutoff density ($7.5 \times 10^{10}$ cm$^{-3}$ in the case of microwaves having a frequency of 2.45 GHz), the microwaves having entered an interface between the dielectric window 107 and the initial high-density plasma cannot propagate into the initial high-density plasma.

Stated another way, when the electron density exceeds the cutoff density, the microwaves having entered the interface between the dielectric window 107 and the initial high-density plasma propagates as the surface wave 115.

More exactly speaking, when the electron density exceeds a surface-wave mode generation threshold density ($3.4 \times 10^{11}$ cm$^{-3}$ in the case using a quartz window), the microwaves having entered the interface between the dielectric window 107 and the initial high-density plasma cannot propagate through the initial high-density plasma.

Accordingly, the microwaves having entered the interface between the dielectric window 107 and the initial high-density plasma propagate as a surface wave 115 along the interface between the dielectric window 107 and the initial high-density plasma.

Further, the surface waves 115 introduced through the plural inner arc-shaped slots 114a interfere with each other, and the surface waves 115 introduced through the outer arc-shaped slots 114b interfere with waves being reflected from an outer peripheral end of the dielectric window 107.

Mutual interference between the surface waves 115, and interference of the surface waves 115 introduced through the outer arc-shaped slots 114b with the waves being reflected from the outer peripheral end of the dielectric window 107, generates the surface standing waves 116 each of which has an "antinode" every 1/2 of the wavelength of the surface wave 115.

With the generation of the surface standing waves 116, primary plasma 117 having ultra-high density and high electron temperature is generated in an outer peripheral portion and a central portion.

Between the inner arc-shaped slots 114a and the outer arc-shaped slots 114b, the surface waves 115 introduced through both the slots 114a and 114b partially cancel each other. Hence the electric fields of the surface waves 115 and the prime plasma 117 are weakened.

Thus, the primary plasma 117 is diffused and relaxed so as to generate the plasma bulk 118 having high density and low electron temperature.

The processing gas is excited, activated and partly decomposed by the high-density and low-electron-temperature plasma, and executes plasma processing of the surface of the target substrate 102 placed on the support 103.

Fig. 3A shows the distribution of electron density near the slot antenna and near the target substrate 502 when the known strong-interference dual arc-shaped slots (i.e., the known slotted endless annular waveguide 508: see Fig. 5A) are employed.

Fig. 3B shows the distribution of electron density near the slot antenna and near the target substrate 102 when the weak-interference dual arc-shaped slots (i.e., the slotted endless annular waveguide 108) according to the first embodiment of the present invention are employed.

More specifically, each of Figs. 3A and 3B shows the result of measuring the distribution of electron density near the slot antenna and near the target substrate 502 or 102 in the plasma under the conditions that the gas is He, the pressure is 0.5 Torr, and the microwave power is 3 kW.

As shown in Fig. 3A, when the known strong-interference dual arc-shaped slots are employed, a ring-like plasma is generated between the inner arc-shaped slots 514a and the outer arc-shaped slots 514b and the distribution of the electron density (electric field strength of the surface wave) is changed near the slot antenna.

Also, when the known strong-interference dual arc-shaped slots are employed, the distribution of the electron density near the target substrate 502 is also affected by the change in the distribution of the electron density (electric field strength of the surface wave) near the slot antenna and a variation of about $\pm$ 5% is measured.

Such a phenomenon is caused due to the fact that the known strong-interference dual arc-shaped slots are not constituted to provide the function of improving the uniformity of the distribution of the electron density of the plasma.

On the other hand, as shown in Fig. 3B, when the weak-interference dual arc-shaped slots (i.e., the slots (slot antennas) 114a and 114b) according to the first embodiment of the present invention are employed, the uniformity of the distribution of the electron density (electric field strength of the surface wave) is increased in the central portion and the outer peripheral portion.

Such a phenomenon is obtained, for example, by performing adjustment so as to reduce the electron density in the region corresponding to the spacing Ls between the inner arc-shaped slots 114a and the outer arc-shaped slots 114b, and to increase the electron densities inside the inner arc-shaped slots 114a and outside the outer arc-shaped slots 114b.

As a result, based on the higher uniformity (optimization) of the distribution of the electron density near the slot antenna, higher uniformity of the distribution of the electron density is measured near the target substrate 102. Namely, the distribution of the electron density is improved to a variation equal to or better than $\pm$ 2%.

Fig. 4A shows the distribution of electron density (electric field strength of the surface wave) near the slotted endless annular waveguide 108 in the first embodiment of the present invention with respect to an angle ratio of the aperture angle Ao of the outer arc-shaped slot 114b to the aperture angle Ai of the inner arc-shaped slot 114a.

Fig. 4B shows a distribution of electron density near the target substrate 102 in the first embodiment of the present invention with respect to the angle ratio of the aperture angle Ao of the outer arc-shaped slot 114b to the aperture angle Ai of the inner arc-shaped slot 114a.

More specifically, each of Figs. 4A and 4B shows the result of measuring the distribution of electron density in the plasma under the conditions that the gas is He, the pressure is 0.5 Torr, and the microwave power is 3 kW.

As shown in Fig. 4A, the distribution of the electron density (electric field strength of the surface wave) near the slotted endless annular waveguide 108 in the first embodiment of the present invention shows a larger change when the angle ratio of the aperture angle Ao to the aperture angle Ai is 0.9 and 1.7.

More specifically, the electron density (electric field strength of the surface wave) near the slotted endless annular waveguide 108 in the first embodiment of the present invention is distributed such that the electron density in the outer peripheral portion is too low when the angle ratio of the aperture angle Ao to the aperture angle Ai is 1.1 or less, and the electron density in the central portion is too low when the angle ratio is 1.5 or more. Thus, the distribution of the electron density is changed to a large extent at those aperture angle ratios.

Further, the distribution of the electron density (electric field strength of the surface wave) near the slotted endless annular waveguide 108 in the first embodiment of the present invention shows a minimum change when the angle ratio of the aperture angle Ao to the aperture angle Ai is 1.1, 1.3 or 1.5, and a satisfactory distribution of the electron density is obtained.

As shown in Fig. 4B, the distribution of the electron density near the target substrate 102 also shows a large change when the angle ratio of the aperture angle Ao to the aperture angle Ai is 0.9 and 1.7.

More specifically, the electron density near the target substrate 102 is distributed such that the electron density in the outer peripheral portion is too low when the angle ratio of the aperture angle Ao to the aperture angle Ai is 1.1 or less, and the electron density in the central portion is too low when the angle ratio is 1.5 or more. Thus, the distribution of the electron density is changed to a large extent at those aperture angle ratios.

Further, the distribution of the electron density near the target substrate 102 shows a minimum change when the angle ratio of the aperture angle Ao to the aperture angle Ai is 1.1, 1.3 or 1.5, and satisfactory uniformity is obtained.

While the microwave frequency used in the microwave plasma processing apparatus according to the first embodiment of the present invention can be applied in the range of 300 MHz to 3 THz, the range of 1 to 10 GHz where the wavelength is comparable to the dimension of the dielectric window 107 is particularly effective.

The dielectric window 107 used in the microwave plasma processing apparatus according to the first embodiment of the present invention is preferably made of a material having sufficient mechanical strength and a small dielectric loss so that microwave transmittance is sufficiently high.

Optimum materials of the dielectric window 107 include, e.g., quartz, alumina (sapphire), aluminum nitride, and carbon fluoride polymer (Teflon (registered trade name)).

The slotted endless annular waveguide 108 used in the microwave plasma processing apparatus according to the first embodiment of the present invention can be made of an electric conductive material, but it is preferably made of a material having electrical conductivity as high as possible so that a microwave transmission loss is minimized.

Optimum materials of the slotted endless annular waveguide 108 include, e.g., Al, Cu, and Ag/Cu-plated SUS (Steel Use Stainless according to JIS).

The direction of an inlet port of the slotted endless annular waveguide 108 used in the first embodiment of the present invention is preferably set to be able to efficiently introduce the microwave to a microwave propagation space within the slotted endless annular waveguide 108.

Stated another way, the direction of the inlet port of the slotted endless annular waveguide 108 can be set, for example, parallel or perpendicular to the H plane, or in a tangential direction to the microwave propagation space, or in two directions distributed to the left and the right in the microwave propagation space.

In the microwave plasma processing apparatus and method according to the first embodiment of the present invention, a magnetic field generating unit can be employed to perform the processing at lower pressure.

In other words, an additional magnetic field can also be applied in the plasma processing apparatus and method according to the first embodiment so long as it is perpendicular to the electric field generated in the widthwise direction of the slot.

The magnetic field generating unit can be constituted by either a coil or a permanent magnet. When a coil is used, a cooling unit, such as a water- or air-cooling device, can be provided to prevent overheating. Further, the surface of the target substrate 102 can be irradiated using ultraviolet light.

Any type of light source can be used so long as it emits light absorbable by the target substrate 102 or gas affixed onto the target substrate 102. Preferable examples of the light source include an excimer laser, an excimer lamp, a rare gas resonance lamp, and a low-pressure mercury lamp.

The pressure in the plasma processing chamber 101 used in the microwave plasma processing method according to the first embodiment of the present invention is preferably set to be in the range of 0.1 mTorr to 10 Torr and more preferably in the range of 10 mTorr to 3 Torr.

A film deposited by the microwave plasma processing method according to the first embodiment of the present invention can be formed by selecting particular kinds of gases used in the processing, as required.

As a first example of the deposit film obtained by the processing, an insulating film, such as $Si_3N_4$, $SiO_2$, SiOF, $Ta_2O_5$, $TiO_2$, TiN, $Al_2O_3$, AlN, $MgF_2$, HfSiO, or HfAlO, can be formed.

As a second example, other various kinds of deposit films can also be efficiently formed, including a semiconductor film such as a-Si, poly-Si, SiC, SiGe or GaAs, an electric conductive film of Al, W, Mo, Ti or Ta, and a carbon film.

The target substrate 102 processed by the plasma processing method according to the first embodiment of the present invention can be a semiconductor, an electric conductive substrate, or an electrically insulating substrate.

Examples of the electric conductive substrate include metals such as Fe, Ni, Cr, Al, Mo, Au, Nb, Ta, V, Ti, Pt and Pb, and alloys of those metals, such as brass and stainless steel.

A first group of examples of the electrically insulating substrate include quartz and other $SiO_2$-based glasses, and inorganic materials such as $Si_3N_4$, NaCl, KCl, LiF, $CaF_2$, $BaF_2$, $Al_2O_3$, AlN and MgO.

A second group of examples of the electrically insulating substrate include organic films and sheets of polyethylene, polyester, polycarbonate, cellulose acetate, polypropylene, polyvinyl chloride, polyvinylidene chloride, polystyrene, polyamide, polyimide, etc.

The direction of the gas introduction unit 105 used in the plasma processing apparatus according to the first embodiment of the present invention is preferably set such that the introduced gas is sufficiently supplied to a central area or thereabout of the plasma processing chamber 101 after passing through a plasma region generated near the dielectric window 107.

The gas introduction unit 105 is optimally structured to spray the gas toward the dielectric window 107 such that, after being sufficiently supplied to the central area or thereabout of the plasma processing chamber 101, the gas flows along the surface of the target substrate 102 from the center toward the outer periphery thereof.

Any number of generally known gases can be employed as the gas used to form a thin film on the target substrate 102 by the CVD process.

The following is examples of material gas that contains Si atoms and is introduced to the plasma processing chamber 101 through the processing-gas introduction unit 105 when a Si-based semiconductor thin film of, e.g., a-Si, poly-Si or SiC is formed.

One group of examples of the material gas in the above case comprises inorganic silanes, such as $SiH_4$ and $Si_2H_6$. Another group of those examples comprises organic silanes, such as tetraethylsilane (TES), tetramethylsilane (TMS), dimethylsilane (DMS), dimethyldifluorosilane (DMDFS), and dimethyldichlorosilane (DMDCS).

Still another group of those examples comprises silane halides, such as $SiF_4$, $Si_2F_6$, $Si_3F_8$, $SiHF_3$, $SiH_2F_2$, $SiCl_4$, $Si_2Cl_6$, $SiHCl_3$, $SiH_2Cl_2$, $SiH_3Cl$, and $SiCl_2F_2$.

An alternative example is a material that is in a gaseous state at room temperature and atmospheric pressure, or a material that can be easily gasified.

Examples of added gas or carrier gas capable of being introduced together and mixed with the Si material gas in the above case include $H_2$, He, Ne, Ar, Kr, Xe, and Rn. On the other hand, when a Si compound-based thin film of, e.g., $Si_3N_4$ and $SiO_2$ is formed, the following is examples of material gas that contains Si atoms and is introduced through the processing-gas introduction unit 105 when a Si-based semiconductor film is formed. A first group of examples of the material gas in the above case comprises inorganic silanes, such as $SiH_4$ and $Si_2H_6$.

A second group of those examples comprises organic silanes, such as tetraethoxylsilane (TEOS), tetramethoxysilane (TMOS), and octamethylcyclotetrasilane (OMCTS).

A third group of those examples comprises other organic silanes, such as dimethyldifluorosilane (DMDFS) and dimethyldichlorosilane (DMDCS).

A fourth group of those examples comprises silane halides, such as $SiF_4$, $Si_2F_6$, $Si_3F_8$, $SiHF_3$, $SiH_2F_2$, $SiCl_4$, $Si_2Cl_6$, $SiHCl_3$, $SiH_2Cl_2$, $SiH_3Cl$, and $SiCl_2F_2$.

An alternative example is a material that is in a gaseous state at room temperature and atmospheric pressure, or a material that can be easily gasified.

Examples of nitrogen material gas or oxygen material gas capable of being introduced together in the above case include $N_2$, $NH_3$, $N_2H_4$, hexamethyldisilazane (HMDS), $O_2$, $O_3$, $H_2O$, NO, $N_2O$, and $NO_2$.

The following is examples of material gas that contains metallic atoms and is introduced through the processing-gas introduction unit 105 when a metallic thin film of, e.g., Al, W, Mo, Ti or Ta is formed. A first group of examples of the material gas in the above case comprises organic metals, such as trimethylaluminum (TMAl).

A second group of those examples comprises other organic metals, such as triethylaluminum (TEAl), triisobutylaluminum (TIBAl), dimethylaluminum hydride (DMAlH), and tungsten carbonyl (W(CO)$_6$).

A third group of those examples comprises still other organic metals, such as molybdenum carbonyl (Mo(CO)$_6$), trimethylgallium (TMGa), triethylgallium (TEGa), tetraisopropoxytitanium (TIPOTi), and pentaethoxytantalum (PEOTa).

A fourth group of those examples comprises metal halides, such as $AlCl_3$, $WF_6$, $TiCl_3$, and $TaCl_5$.

Examples of added gas or carrier gas capable of being introduced together and mixed with the material gas in the above case include $H_2$, He, Ne, Ar, Kr, Xe, and Rn.

The following is examples of material gas that contains metallic atoms and is introduced through the processing-gas introduction unit 105 when a metallic-compound thin film of, e.g., $Al_2O_3$, AlN, $Ta_2O_5$, $TiO_2$, TiN or $WO_3$ is formed.

A first group of examples of the material gas in the above case comprises organic metals, such as trimethylaluminum (TMA1), triethylaluminum (TEAl), triisobutylaluminum (TIBAl), and dimethylaluminum hydride (DMA1H).

A second group of those examples comprises other organic metals, such as tungsten carbonyl ($W(CO)_6$), molybdenum carbonyl ($Mo(CO)_6$), and trimethylgallium (TMGa).

A third group of those examples comprises still other organic metals, such as triethylgallium (TEGa), tetraisopropoxytitanium (TIPOTi), and pentaethoxytantalum (PEOTa). A fourth group of those examples comprises metal halides, such as $AlCl_3$, $WF_6$, $TiCl_3$, and $TaCl_5$.

Examples of oxygen material gas or nitrogen material gas capable of being introduced together in the above case include $O_2$, $O_3$, $H_2O$, NO, $N_2O$, $NO_2$, $N_2$, $NH_3$, $N_2H_4$, and hexamethyldisilazane (HMDS).

The following are examples of material gas that is introduced through the processing-gas introduction unit 105 when a carbon-based thin film of, e.g., graphite, a carbon nano-tube (CNT), diamond-like carbon (DLC), or diamond is formed.

While material containing carbon atoms are usable, a first group of examples of the material gas in the above case comprises saturated hydrocarbons such as $CH_4$, $C_2H_6$ and $C_3H_8$, unsaturated hydrocarbons such as $C_2H_4$, $C_3H_6$, $C_2H_2$ and $C_3H_4$, and aromatic hydrocarbons such as $C_6H_6$.

A second group of those examples comprises alcohols such as $C_3OH$ and $C_2H_5OH$, ketones such as $(CH_3)_2CO$, aldehydes such as $CH_3CHO$, and carboxylic acids such as $HCOOH$ and $CH_3COOH$.

Examples of etching gas introduced through the processing-gas introduction unit 105 in etching of the substrate surface include $F_2$, $CF_4$, $CH_2F_2$, $C_2F_6$, $C_3F_8$, $C_4F_8$, $CF_2Cl_2$, $SF_6$, $NF_3$, $Cl_2$, $CCl_4$, $CH_2Cl_2$, and $C_2Cl_6$. Examples of ashing gas introduced through the processing-gas introduction unit 105 in the case of removing organic components on the substrate surface, such as a photoresist, by ashing include $O_2$, $O_3$, $H_2O$, NO, $N_2O$, $NO_2$, $N_2$ and $H_2$.

When the microwave plasma processing apparatus and method according to the first embodiment of the present invention is applied to surface modification, the following processes can be performed by properly selecting gases used.

For example, when any of Si, Al, Ti, Zn, Ta, etc. is used as a substrate or a surface layer thereof, it is possible to perform not only a process of oxidizing or nitriding the substrate or the surface layer, but also a process of doping B, As, P, etc.

Further, the film forming technique practiced in accordance with the present invention can also be applied to a cleaning process. In that case, cleaning of oxides, organic materials, heavy metals, etc. can be realized.

Examples of oxidizing gas introduced through the processing-gas introduction unit 105 for surface treatment of the substrate by oxidization include $O_2$, $O_3$, $H_2O$, NO, $N_2O$, and $NO_2$. Examples of nitriding gas introduced through the processing-gas introduction unit 105 for surface treatment of the substrate by nitriding include $N_2$, $NH_3$, $N_2H_4$, and hexamethyldisilazane (HMDS).

Examples of cleaning/ashing gas introduced through the processing-gas introduction unit 105 in the case of cleaning organic materials on the substrate surface or removing organic materials on the substrate surface, such as a photoresist, by ashing include $O_2$, $O_3$, $H_2O$, NO, $N_2O$, $NO_2$, $N_2$, and $H_2$ Examples of cleaning gas introduced through the processing-gas introduction unit 105 in the case of cleaning inorganic materials on the substrate surface include $F_2$, $CF_4$, $CH_2F_2$, $C_2F_6$, $C_4F_8$, $CF_2Cl_2$, $SF_6$, and $NF_3$.

In the first embodiment of the present invention, as described above, the interval (distance or spacing) Ls between the centerlines of the inner and outer arc-shaped slots 114a, 114b is set to be an even multiple of the half wavelength of the surface wave 115. The interval (distance) Le between the centerline of the outer arc-shaped slot 114b and the outer periphery of the dielectric window 107 is set to be an odd multiple of the half wavelength of the surface wave 115. The interval (distance) between the centerlines of the inner arc-shaped slots 114a, which are positioned symmetrically about an axis, is set to be an integer multiple of the half wavelength of the surface wave 115. The aperture angle Ao of the outer arc-shaped slot 114b is set to be in the range of 1.1 to 1.5 times the aperture angle Ai of the inner arc-shaped slot 114a.

Further, the distance between the dielectric window 107 and the support 103 is set to be in the range of 30 mm to 120 mm. The interval Ls (distance or spacing) between the centerline of the inner and outer arc-shaped slots 114a, 114b is adjusted so as to reduce the electron density of the plasma therebetween, and to increase the electron density of the plasma inside the centerline of the inner arc-shaped slot 114a and outside the centerline of the outer arc-shaped slot 114b.

With the construction described above, the electric field strength of the surface wave in each of the peripheral portion and the central portion of the slotted endless annular waveguide 108 can be intensified and the distribution of the electron density in the radial direction of the slotted endless annular waveguide 108 can be optimized.

Therefore, higher uniformity can be realized in the distribution of the electron density of the plasma near the target substrate 102 under plasma processing, and uniform and satisfactory plasma processing can be performed on the target substrate 102 with higher accuracy. As a result, quality and reliability of the plasma processing can be improved.

Second Embodiment

A second embodiment of the present invention will be described next in connection with a practical example.

Ashing of a photoresist layer was performed by using the microwave plasma processing apparatus shown in Figs. 1A, 1B, 2A and 2B.

A silicon (Si) substrate (diameter 300 mm) immediately after etching an interlayer $SiO_2$ film and forming a via hole was used as the target substrate 102. In the following description, it is called the Si substrate 102.

First, the Si substrate 102 was placed on the support 103 and heated to 250°C by using the heater 104. The interior of the plasma processing chamber 101 was evacuated through the evacuation system (not shown) to a pressure of $10^{-4}$ Torr.

Oxygen gas was introduced to the plasma processing chamber 101 at a flow rate of 2 slm through the plasma processing-gas introduction unit 105. The conductance valve (not shown) disposed in the evacuation system (not shown) was adjusted to hold a pressure level in the plasma processing chamber 101 at 1.5 Torr.

Then, electric power of 2.5 kW was supplied to the plasma processing chamber 101 from the microwave power supply of 2.45 GHz through the slotted endless annular waveguide 108. Plasma was thereby generated in the plasma processing chamber 101.

In that operation, the oxygen gas introduced through the plasma processing-gas introduction unit 105 was partially dissociated into oxygen atoms through excitation, decomposition and reaction in the plasma processing chamber 101. The oxygen atoms were transported toward the Si substrate 102 to oxidize the photoresist on the Si substrate 102 to form carbon dioxide, thus removing it.

After the ashing, evaluation was made, by way of example, on a gate breakdown, an ashing rate, and a surface charge density of the substrate.

The resulting ashing rate showed very satisfactory uniformity of $\pm$ 2.4% (6.1 $\mu$m/min), and the surface charge density showed a sufficiently low value of $0.6 \times 10^{11}$ cm$^{-2}$. No gate breakdown was observed.

Thus, in the plasma processing, higher uniformity was realized in the distribution of the electron density of the plasma near the Si substrate 102, and the ashing could be satisfactorily performed on the Si substrate 102 with high accuracy.

Third Embodiment

A third embodiment of the present invention will be described next in connection with a practical example.

Ashing of a photoresist layer was performed by using the microwave plasma processing apparatus shown in Figs. 1A, 1B, 2A and 2B.

A silicon (Si) substrate (diameter 300 mm) immediately after etching an interlayer $SiO_2$ film and forming a via hole was used as the target substrate 102. In the following description, it is called the Si substrate 102.

First, the Si substrate 102 was placed on the support 103 and heated to 250°C by using the heater 104. The interior of the plasma processing chamber 101 was evacuated through the evacuation system (not shown) to a pressure of $10^{-5}$ Torr.

Oxygen gas was introduced to the plasma processing chamber 101 at a flow rate of 2 slm through the plasma processing-gas introduction unit 105. The conductance valve (not shown) disposed in the evacuation system (not shown) was adjusted to hold a pressure level in the plasma processing chamber 101 at 2 Torr.

Then, electric power of 2.5 kW was supplied to the plasma processing chamber 101 from the microwave power supply of 2.45 GHz through the slotted endless annular waveguide 108. Plasma was thereby generated in the plasma processing chamber 101.

In that operation, the oxygen gas introduced through the plasma processing-gas introduction unit 105 was partially dissociated into oxygen atoms through excitation, decomposition and reaction in the plasma processing chamber 101. The oxygen atoms were transported toward the Si substrate 102 to oxidize the photoresist on the Si substrate 102 to carbon dioxide, thus removing it.

After the ashing, evaluation was made, by way of example, on a gate breakdown, an ashing rate, and a surface charge density of the substrate.

The resulting ashing rate showed very satisfactory uniformity of $\pm$ 3.1% (7.9 $\mu$m/min), and the surface charge density showed a sufficiently low value of $1.0 \times 10^{11}$ cm$^{-2}$. No gate breakdown was observed.

Thus, in the plasma processing, higher uniformity was realized in the distribution of the electron density of the plasma near the Si substrate 102, and the ashing could be satisfactorily performed on the Si substrate 102 with high accuracy.

Fourth Embodiment

A fourth embodiment of the present invention will be described next in connection with a practical example.

Surface nitriding of a very thin oxide film was performed by using the microwave plasma processing apparatus shown in Figs. 1A, 1B, 2A and 2B.

A silicon (Si) substrate (diameter 200 mm) coated with a surface oxide film having a thickness of 1.6 nm was used as the target substrate 102. In the following description, it is called the Si substrate 102.

First, the Si substrate 102 was placed on the support 103 and heated to 150°C by using the heater 104. The interior of the plasma processing chamber 101 was evacuated through the evacuation system (not shown) to a pressure of $10^{-3}$ Torr.

Nitrogen gas and helium gas were introduced to the plasma processing chamber 101 at a flow rate of 50 sccm and 450 sccm, respectively, through the plasma processing-gas introduction unit 105.

Then, the conductance valve (not shown) disposed in the evacuation system (not shown) was adjusted to hold a pressure level in the plasma processing chamber 101 at 0.2 Torr.

Electric power of 1.5 kW was supplied to the plasma processing chamber 101 from the microwave power supply of 2.45 GHz through the slotted endless annular waveguide 108. Plasma was thereby generated in the plasma processing chamber 101.

In that operation, the nitrogen gas introduced through the plasma processing-gas introduction unit 105 was partially dissociated into nitrogen ions and atoms through excitation, decomposition and reaction in the plasma processing chamber 101. The nitrogen ions and atoms were transported toward the Si substrate 102 to nitride the surface of the oxide film on the Si substrate 102.

After the nitriding, evaluation was made, by way of example, on a gate breakdown, a nitriding rate, and a surface charge density of the substrate.

The resulting nitriding rate showed very satisfactory uniformity of $\pm$ 1.5%, and the surface charge density showed a sufficiently low value of $0.9 \times 10^{11}$ cm$^{-2}$. No gate breakdown was observed. Thus, in the plasma processing, higher uniformity was realized in the distribution of the electron density of the plasma near the Si substrate 102, and the surface nitriding of the very thin oxide film could be satisfactorily performed on the Si substrate 102 with high accuracy.

Fifth Embodiment

A fifth embodiment of the present invention will be described next in connection with a practical example.

Direct nitriding of a silicon substrate was performed by using the microwave plasma processing apparatus shown in Figs. 1A, 1B, 2A and 2B.

A bare silicon (Si) substrate (diameter 200 mm) was used as the target substrate 102. In the following description, it is called the Si substrate 102.

First, the Si substrate 102 was placed on the support 103 and heated to 150°C by using the heater 104. The interior of the plasma processing chamber 101 was evacuated through the evacuation system (not shown) to a pressure of $10^{-3}$ Torr.

Nitrogen gas was introduced to the plasma processing chamber 101 at a flow rate of 500 sccm through the plasma processing-gas introduction unit 105. The conductance valve (not shown) disposed in the evacuation system (not shown) was adjusted to hold a pressure level in the plasma processing chamber 101 at 0.1 Torr.

Then, electric power of 1.5 kW was supplied to the plasma processing chamber 101 from the microwave power supply of 2.45 GHz through the slotted endless annular waveguide 108. Plasma was thereby generated in the plasma processing chamber 101.

In that operation, the nitrogen gas introduced through the plasma processing-gas introduction unit 105 was partially dissociated into nitrogen ions and atoms through excitation, decomposition and reaction in the plasma processing chamber 101. The nitrogen ions and atoms were transported toward the Si substrate 102 to directly nitride the surface of the Si substrate 102.

After the nitriding, evaluation was made, by way of example, on a gate breakdown, a nitriding rate, and a surface charge density of the substrate.

The resulting nitriding rate showed very satisfactory uniformity of $\pm$ 1.1%, and the surface charge density showed a sufficiently low value of $1.7 \times 10^{11}$ cm$^{-2}$. No gate breakdown was observed. Thus, in the plasma processing, higher uniformity was realized in the distribution of the electron density of the plasma near the Si substrate 102, and the direct nitriding could be satisfactorily performed on the Si substrate 102 with high accuracy.

Sixth Embodiment

A sixth embodiment of the present invention will be described next in connection with a practical example.

A silicon nitride film for protecting a semiconductor device was formed by using the microwave plasma processing apparatus shown in Figs. 1A, 1B, 2A and 2B.

A P-type single-crystal silicon substrate (diameter 300 mm, plane orientation <100> and resistivity of 10 Ωcm) having an Al wiring pattern (with a line and a space of 0.5 μm) and including an interlayer $SiO_2$ film was used as the target substrate 102. In the following description, it is called the Si substrate 102.

First, the Si substrate 102 was placed on the support 103. The interior of the plasma processing chamber 101 was evacuated through the evacuation system (not shown) to a pressure of $10^{-7}$ Torr. Then, the heater 104 was energized to heat the Si substrate 102 to 300°C, following which the substrate was held at that temperature. Nitrogen gas and monosilane gas were introduced to the plasma processing chamber 101 at a flow rate of 600 sccm and 200 sccm, respectively, through the plasma processing-gas introduction unit 105.

Then, the conductance valve (not shown) disposed in the evacuation system (not shown) was adjusted to hold a pressure level in the plasma processing chamber 101 at 20 mTorr.

Electric power of 3.0 kW was supplied to the plasma processing chamber 101 from the microwave power supply (not shown) of 2.45 GHz through the slotted endless annular waveguide 108. Plasma was thereby generated in the plasma processing chamber 101.

In that operation, the nitrogen gas introduced through the plasma processing-gas introduction unit 105 was partially dissociated into nitrogen atoms through excitation and decomposition in the plasma processing chamber 101. The nitrogen atoms were transported toward the Si substrate 102 to react with the monosilane gas, thus forming a silicon nitride film on the Si substrate 102.

Particularly, the silicon nitride film was formed on the Si substrate 102 at a thickness of 1.0 μm. After the film forming, evaluation was made, by way of example, on a gate breakdown, a film forming rate, and film properties such as stress.

The stress was evaluated by measuring a change in warping of the substrate between before and after the film forming with a laser interferometer Zygo (registered trade name). The resulting film-forming rate of the silicon nitride film showed very satisfactory uniformity of ± 2.6% (530 nm/min).

The measured film properties showed stress of $0.9 \times 10^9$ dyne·$cm^{-2}$ (compression), a leak current of $1.1 \times 10^{-10}$ A·$cm^{-2}$, and a dielectric withstand voltage of 10.7 MV/cm. In other words, it was confirmed that an extremely excellent film was obtained. In addition, no gate breakdown was observed.

Thus, in the plasma processing, higher uniformity was realized in the distribution of the electron density of the plasma near the Si substrate 102, and the silicon nitride film for protecting a semiconductor device could be satisfactorily formed with high accuracy.

Seventh Embodiment

A seventh embodiment of the present invention will be described next in connection with a practical example.

A silicon oxide film and a silicon nitride film for preventing reflection from a plastic lens were formed by using the microwave plasma processing apparatus shown in Figs. 1A, 1B, 2A and 2B.

A plastic convex lens with a diameter of 50 mm was used as the target substrate 102. In the following description, it is called the lens 102.

First, the lens 102 was placed on the support 103. The interior of the plasma processing chamber 101 was evacuated through the evacuation system (not shown) to a pressure of $10^{-7}$ Torr.

Nitrogen gas and monosilane gas were introduced to the plasma processing chamber 101 at a flow rate of 150 sccm and 70 sccm, respectively, through the plasma processing-gas introduction unit 105.

Then, the conductance valve (not shown) disposed in the evacuation system (not shown) was adjusted to hold a pressure level in the plasma processing chamber 101 at 5 mTorr.

Electric power of 3.0 kW was supplied to the plasma processing chamber 101 from the microwave power supply (not shown) of 2.45 GHz through the slotted endless annular waveguide 108. Plasma was thereby generated in the plasma processing chamber 101.

In that operation, the nitrogen gas introduced through the plasma processing-gas introduction unit 105 was partially dissociated into active species, such as nitrogen atoms, through excitation and decomposition in the plasma processing chamber 101. The active species were transported toward the lens 102 to react with the monosilane gas, thus forming the silicon nitride film on the lens 102.

Particularly, the silicon nitride film was formed on the lens 102 to a thickness of 20 nm. Thereafter, oxygen gas and monosilane gas were introduced to the plasma processing chamber 101 at a flow rate of 200 sccm and 100 sccm, respectively, through the plasma processing-gas introduction unit 105.

Then, the conductance valve (not shown) disposed in the evacuation system (not shown) was adjusted to hold a pressure level in the plasma processing chamber 101 at 2 mTorr.

Electric power of 2.0 kW was supplied to the plasma processing chamber 101 from the microwave power supply (not shown) of 2.45 GHz through the slotted endless annular waveguide 108. Plasma was thereby generated in the plasma processing chamber 101.

In that operation, the oxygen gas introduced through the plasma processing-gas introduction unit 105 was partially dissociated into active species, such as oxygen atoms, through excitation and decomposition in the plasma processing chamber 101. The active species were transported toward the lens 102.

The oxygen gas reacts with the monosilane gas and the silicon oxide film was formed on the lens 102 in a thickness of 85 nm. After the film was formed, evaluation was made, by way of example, on a gate breakdown, a film forming rate, and a reflection characteristic.

The resulting film-forming rates of the silicon nitride film and the silicon oxide film showed satisfactory uniformity of $\pm$ 2.7% (380 nm/min) and $\pm$ 2.9% (410 nm/min). Regarding the film properties, the measured reflectance was 0.14% near 500 nm and very satisfactory optical characteristics were confirmed.

Thus, in the plasma processing, higher uniformity was realized in the distribution of the electron density of the plasma near the lens 102, and the silicon oxide film and the silicon nitride film for preventing reflection from the plastic lens could be satisfactorily formed with high accuracy.

Eighth Embodiment

An eighth embodiment of the present invention will be described next in connection with a practical example.

An interlayer insulating silicon oxide film for a semiconductor device was formed by using the microwave plasma processing apparatus shown in Figs. 1A, 1B, 2A and 2B.

A P-type 300-mm diameter single-crystal silicon substrate (plane orientation <100> and resistivity of 10 Ωcm) having an Al wiring pattern (with a line and a space of 0.5 $\mu$m) formed at a top thereof was used as the target substrate 102. In the following description, it is called the Si substrate 102.

First, the Si substrate 102 was placed on the support 103. The interior of the plasma processing chamber 101 was evacuated through the evacuation system (not shown) to a pressure of $10^{-7}$ Torr.

Then, the heater 104 was energized to heat the Si substrate 102 to 300°C, following which the substrate was held at that temperature.

Oxygen gas and monosilane gas were introduced to the plasma processing chamber 101 at a flow rate of 400 sccm and 200 sccm, respectively, through the plasma processing-gas introduction unit 105.

Then, the conductance valve (not shown) disposed in the evacuation system (not shown) was adjusted to hold a pressure level in the plasma processing chamber 101 at 20 mTorr.

Electric power of 300 W was applied to the support 103 through a unit for applying a radio-frequency (RF) wave of 2 MHz, and at the same time electric power of 2.5 kW was supplied to the plasma processing chamber 101 from the microwave power supply of 2.45 GHz through the slotted endless annular waveguide 108.

Plasma was thereby generated in the plasma processing chamber 101. The oxygen gas introduced through the plasma processing-gas introduction unit 105 was partially dissociated into active species through excitation and decomposition in the plasma processing chamber 101. The active species were transported toward the Si substrate 102.

The oxygen gas reacts with the monosilane gas, thus forming the silicon oxide film on the Si substrate 102 in a thickness of 0.8 $\mu$m. On that occasion, ion species were accelerated by an RF bias to impinge upon the Si substrate 102. As a result, the surface flatness was improved.

After the processing, evaluation was made on a film forming rate, uniformity, a dielectric withstanding voltage, and a step coverage. The step coverage was evaluated by observing a cross-section of the silicon oxide film formed on the Al wiring pattern with a scanning electron microscope (SEM) and by checking voids.

The resulting film-forming rate of the silicon oxide film showed satisfactory uniformity of $\pm$ 2.8% (310 nm/min). Regarding film properties, the dielectric withstand voltage was 10.1 MV/cm and the formed film was void-free. In other words, it was confirmed that an excellent film was obtained. In addition, no gate breakdown was observed.

Thus, in the plasma processing, higher uniformity was realized in the distribution of the electron density of the plasma near the Si substrate 102, and the interlayer insulating silicon oxide film for a semiconductor device could be satisfactorily formed with high accuracy.

Ninth Embodiment

A ninth embodiment of the present invention will be described next in connection with a practical example.

Etching of an interlayer $SiO_2$ film in a semiconductor device was performed by using the microwave plasma processing apparatus shown in Figs. 1A, 1B, 2A and 2B.

A P-type 300-mm diameter single-crystal silicon substrate (plane orientation <100> and resistivity of 10 Ωcm) having an interlayer $SiO_2$ film with a thickness of 1 $\mu$m formed on an Al wiring pattern (with a line and a space of 0.35 $\mu$m) was used as the target substrate 102. In the following description, it is called the Si substrate 102.

First, the Si substrate 102 was placed on the support 103. The interior of the plasma processing chamber 101 was evacuated through the evacuation system (not shown) to a pressure of $10^{-7}$ Torr. $C_4F_8$, Ar and $O_2$ were introduced to the plasma processing chamber 101 at a flow rate of 80 sccm, 120 sccm and 40 sccm, respectively, through the plasma processing-gas introduction unit 105. Thereafter, the conductance valve (not shown) disposed in the evacuation system (not shown) was adjusted to hold the pressure level in the plasma processing chamber 101 at 5 mTorr.

Then, electric power of 280 W was applied to the support 103 through a unit for applying a radio-frequency (RF) wave of 2 MHz, and at the same time electric power of 3.0 kW was supplied to the plasma processing chamber 101 from the microwave power supply of 2.45 GHz through the slotted endless annular waveguide 108.

Plasma was thereby generated in the plasma processing chamber 101. The $C_4F_8$ gas introduced through the plasma processing-gas introduction unit 105 was partially dissociated into active species through excitation and decomposition in the plasma processing chamber 101. The active species were transported toward the Si substrate 102.

Ions in the plasma processing gas ($C_4F_8$ gas) transported toward the Si substrate 102 were accelerated under a self-biased condition, thus etching the interlayer $SiO_2$ film.

A rise of the temperature of the Si substrate 102 was held at 30°C by a cooler provided with an electrostatic chuck. After the etching, evaluation was made on a gate breakdown, an etching rate, a selectivity, and an etched shape.

The etched shape was evaluated by observing a cross-section of the etched silicon oxide film with a scanning electron microscope (SEM).

The evaluation result showed satisfactory uniformity of the etching rate and satisfactory selectivity with respect to polysilicon at a level of $\pm$ 2.7% (580 nm/min) and 25:1. It was also confirmed that the etched shape was substantially vertical and micro-loading effects were small. In addition, no gate breakdown was observed.

Thus, in the plasma processing, higher uniformity was realized in the distribution of the electron density of the plasma near the Si substrate 102, and the interlayer $SiO_2$ film for a semiconductor device could be satisfactorily etched with high accuracy.

Tenth Embodiment

A tenth embodiment of the present invention will be described next in connection with a practical example.

Etching of a polysilicon film between gate electrodes in a semiconductor device was performed by using the microwave plasma processing apparatus shown in Figs. 1A, 1B, 2A and 2B.

A P-type 300-mm diameter single-crystal silicon substrate (plane orientation <100> and resistivity of 10 Ωcm) having a polysilicon film formed at a top thereof was used as the target substrate 102. In the following description, it is called the Si substrate 102.

First, the Si substrate 102 was placed on the support 103. The interior of the plasma processing chamber 101 was evacuated through the evacuation system (not shown) to a pressure of $10^{-7}$ Torr. $CF_4$ gas and oxygen were introduced to the plasma processing chamber 101 at a flow rate of 300 sccm and 20 sccm, respectively, through the plasma processing-gas introduction unit 105.

Then, the conductance valve (not shown) disposed in the evacuation system (not shown) was adjusted to hold a pressure level in the plasma processing chamber 101 at 2 mTorr.

Electric power of 300 W was applied to the support 103 from a power supply (not shown) for a radio-frequency (RF) wave of 2 MHz, and at the same time electric power of 2.0 kW was supplied to the plasma processing chamber 101 from the microwave power supply of 2.45 GHz through the slotted endless annular waveguide 108.

Plasma was thereby generated in the plasma processing chamber 101. The $CF_4$ gas and the oxygen introduced through the plasma processing-gas introduction unit 105 were partially dissociated into active species through excitation and decomposition in the plasma processing chamber 101. The active species were transported toward the Si substrate 102.

Ions dissociated from the $CF_4$ gas and the oxygen were accelerated under a self-biased condition, thus etching the polysilicon film.

A rise of the temperature of the Si substrate 102 was held at 30°C by a cooler provided with an electrostatic chuck. After the etching, evaluation was made on a gate breakdown, an etching rate, a selectivity, and an etched shape.

The etched shape was evaluated by observing a cross-section of the etched polysilicon film with a scanning electron microscope (SEM).

The evaluation result showed satisfactory uniformity of the etching rate and satisfactory selectivity with respect to $SiO_2$ at a level of $\pm$ 2.8% (740 nm/min) and 24:1. It was also confirmed that the etched shape was vertical and micro-loading effects were small. In addition, no gate breakdown was observed.

Thus, in the plasma processing, higher uniformity was realized in the distribution of the electron density of the plasma near the Si substrate 102, and the polysilicon film between gate electrodes in a semiconductor device could be satisfactorily etched with high accuracy.

While the present invention has been described with reference to exemplary embodiments, it is to be understood that the invention is not limited to the disclosed exemplary embodiments. The scope of the following claims is to be accorded the broadest interpretation so as to encompass all modifications, equivalent structures and functions.

**Claims**

1. A plasma processing apparatus comprising:

    microwave introduction means (111, 112) arranged to introduce a microwave from a microwave generation unit;
    a plasma processing chamber (101) having a dielectric window (107);
    substrate support means (103) arranged in the plasma processing chamber to support a substrate (102) to be processed;
    gas introduction means (105) configured to introduce processing gas to the plasma processing chamber;
    evacuation means (106) arranged to evacuate the plasma processing chamber; and
    a waveguide (108) disposed in contact with the outside of the dielectric window and having slots (114a, 114b) through which microwaves are introduced from the microwave introduction means to the plasma processing chamber through the dielectric window,
    the slots comprising an inner arc-shaped slot (114a) and an outer arc-shaped slot (114b) arranged to lie on two concentric circles of different diameters,

    **characterized in that** a distance (Ls) between a centerline of the inner arc-shaped slot and a centerline of the outer arc-shaped slot is adapted to be an even multiple of the half wavelength of a microwave surface wave (115) propagating along the surface of the dielectric window in use.

2. A plasma processing apparatus as claimed in claim 1, in which a distance (Le) between the centerline of the outer arc-shaped slot and an outer periphery of the dielectric window is set to be an odd multiple of the half wavelength of the said microwave surface wave.

3. A plasma processing apparatus as claimed in claim 1 or 2, in which a distance between the centerlines of two inner arc-shaped slots, which are positioned symmetrically about an axis, is set to be an integer multiple of the half wavelength of the said microwave surface wave.

4. A plasma processing apparatus as claimed in any preceding claim, in which the aperture angle (Ao) of the outer arc-shaped slot is set to be in the range of 1.1 to 1.5 times the aperture angle (Ai) of the inner arc-shaped slot.

5. A plasma processing apparatus as claimed in any preceding claim, in which the distance between the dielectric window and the substrate support unit is set to be in the range of 30 mm to 120 mm.

6. A plasma processing apparatus as claimed in any preceding claim, in which the distance between the centerline of the inner arc-shaped slot and the centerline of the outer arc-shaped slot is adjusted such that electron density of plasma (118) is reduced between the centerline of the inner arc-shaped slot and the centerline of the outer arc-shaped slot, and that the electron density of the plasma is increased inside the centerline of the inner arc-shaped slot and outside the centerline of the outer arc-shaped slot.

7. A plasma processing method practiced using a plasma processing apparatus according to any one of Claims 1 to 6, the method comprising the steps of:

    evacuating a plasma processing chamber (101);
    introducing processing gas to the plasma processing chamber; and
    introducing a microwave from a microwave generation means to the plasma processing chamber to generate a plasma (118) for processing a target substrate (102).

# FIG. 1A

# FIG. 1B

$$Ls = n\lambda s$$

$$Le = (2m+1)\lambda s/2$$

$$Lc = l\lambda s/4$$

(n, m, l: INTEGER)

# FIG. 2A

IIB

108

112

114b

114a

IIB

# FIG. 2B

112

114b

114a

107

115

116

117

116

117

115

108

118

EP 1 895 565 A1

## FIG. 3A

## FIG. 3B

19

## FIG. 4A

## FIG. 4B

# FIG. 5A
# PRIOR ART

# FIG. 5B
# PRIOR ART

$$Ls = (2n+1)\lambda s / 2$$
(n: INTEGER)

# FIG. 6A
## PRIOR ART

VIB

508

512

514b

514a

VIB

# FIG. 6B
## PRIOR ART

514b    514a    507

516    516

515    517    517    515    508

518

**European Patent Office**

**EUROPEAN SEARCH REPORT**

Application Number

EP 07 11 5466

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/045674 A1 (ISHII NOBUO [JP] ET AL) 11 March 2004 (2004-03-11) | 1,7 | INV. H01J37/32 |
| Y | | 5 | |
| A | | 2-4,6 | |
| | * paragraphs [0025] - [0030]; figure 1 * * paragraphs [0031] - [0033], [0035]; figures 2A,B * * paragraph [0034]; figures 3C,D * * paragraph [0037]; figure 4A * | | |
| Y | US 2005/136576 A1 (ISHIHARA SHIGENORI [JP] ET AL) 23 June 2005 (2005-06-23) | 5 | |
| A | | 1-4,6,7 | |
| | * paragraphs [0032], [0034]; figure 1 * * paragraph [0056]; figure 8b * | | |
| Y | EP 0 777 257 A (TOKYO SHIBAURA ELECTRIC CO [JP]) 4 June 1997 (1997-06-04) * page 7, lines 50,51; figure 8 * | 5 | |
| A | US 2004/112541 A1 (ISHII NOBUO [JP] ET AL) 17 June 2004 (2004-06-17) * paragraph [0007]; figure 6 * * paragraph [0030] * * paragraph [0059]; figure 2 * * paragraphs [0062], [0064], [0065]; figure 3A * | 1-7 | TECHNICAL FIELDS SEARCHED (IPC)  H01J H05H |
| A | JP 05 198388 A (HITACHI LTD) 6 August 1993 (1993-08-06) * abstract; figure 13 * | 1-7 | |
| A | US 2002/148564 A1 (ISHII NOBUO [JP] ET AL) 17 October 2002 (2002-10-17) * paragraphs [0083], [0084]; figures 3,5 * | 1-7 | |

-/--

The present search report has been drawn up for all claims

| Place of search | Date of completion of the search | Examiner |
|---|---|---|
| The Hague | 1 November 2007 | Hofmann, Kerrin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# EUROPEAN SEARCH REPORT

**European Patent Office**

**Application Number**

EP 07 11 5466

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2006/001253 A (UNIV KYOTO [JP]; TOKYO ELECTRON LTD [JP]; ONO KOUICHI [JP]; KOUSAKA HI) 5 January 2006 (2006-01-05) * abstract; figure 8A * ----- | 1-7 | |

TECHNICAL FIELDS SEARCHED (IPC)

The present search report has been drawn up for all claims

| Place of search | Date of completion of the search | Examiner |
|---|---|---|
| The Hague | 1 November 2007 | Hofmann, Kerrin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 11 5466

This annex lists the patent family members relating to the patent documents cited in the above-mentioned European search report.
The members are as contained in the European Patent Office EDP file on
The European Patent Office is in no way liable for these particulars which are merely given for the purpose of information.

01-11-2007

| Patent document cited in search report | | Publication date | Patent family member(s) | | Publication date |
|---|---|---|---|---|---|
| US 2004045674 | A1 | 11-03-2004 | AU | 7672501 A | 18-02-2002 |
| | | | WO | 0213250 A1 | 14-02-2002 |
| | | | JP | 2002050615 A | 15-02-2002 |
| US 2005136576 | A1 | 23-06-2005 | JP | 2005175028 A | 30-06-2005 |
| EP 0777257 | A | 04-06-1997 | DE | 69603930 D1 | 30-09-1999 |
| | | | DE | 69603930 T2 | 17-02-2000 |
| US 2004112541 | A1 | 17-06-2004 | CN | 1494737 A | 05-05-2004 |
| | | | WO | 02078072 A1 | 03-10-2002 |
| | | | JP | 2002280367 A | 27-09-2002 |
| JP 5198388 | A | 06-08-1993 | JP | 3123175 B2 | 09-01-2001 |
| US 2002148564 | A1 | 17-10-2002 | EP | 1276356 A1 | 15-01-2003 |
| | | | WO | 0176329 A1 | 11-10-2001 |
| | | | TW | 497367 B | 01-08-2002 |
| | | | US | 2005211382 A1 | 29-09-2005 |
| WO 2006001253 | A | 05-01-2006 | CN | 1998272 A | 11-07-2007 |
| | | | KR | 20070053168 A | 23-05-2007 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000138171 A